# EUROPEAN PATENT APPLICATION

(11) **EP 4 694 191 A1**
(43) Date of publication of application: **11.02.2026**
(21) Application number: 24899158.0
(22) Date of filing: 31.05.2024
(51) Int. Cl.: H04R 1/10

(54) **ACOUSTIC OUTPUT APPARATUS**

(30) Priority: 05.12.2023 WO PCT/CN2023/136558
(71) Applicant: Shenzhen Shokz Co., Ltd., Shenzhen, Guangdong 518108 (CN)
(72) Inventor: ZHU, Guangyuan, Shenzhen, Guangdong 518108 (CN); XIE, Shuailin, Shenzhen, Guangdong 518108 (CN); QI, Xin, Shenzhen, Guangdong 518108 (CN)
(74) Representative: Wang, Bo
(86) International application number: PCT/CN2024/096875
(87) International publication number: WO 2025/118506

(57) **Abstract**

The present disclosure relates to an acoustic output device, and in particular, to the technical field of electronic devices. A housing (10) is provided with a sound outlet hole (103), a first pressure relief hole (104), and a second pressure relief hole (105). The sound outlet hole (103) is in communication with a first acoustic cavity (201), and the first pressure relief hole (104) and the second pressure relief hole (105) are in fluid communication with a second acoustic cavity (202). The housing (10) defines a first direction, a second direction, and a third direction that are orthogonal to each other. The housing (10) includes a first housing wall (1101) and a second housing wall (1102) arranged at intervals in the first direction, and the housing further includes a third housing wall (1103) connecting the first housing wall (1101) and the second housing wall (1102). The first pressure relief hole (104) is disposed on the third housing wall (1103), and the second pressure relief hole (105) is disposed on the second housing wall (1102). In a wearing state, the first housing wall (1101) faces toward a head of a user, the second housing wall (1102) is arranged at a side of the first housing wall (1101) opposite to the head of the user, and the third housing wall (1103) is located on a side of the housing (10) opposite to a crown of the head of the user in the third direction. In certain scenarios, the present disclosure can, at least during exercise, improve the deterioration of acoustic performance caused by the first pressure relief hole (104) being covered by the user's sweat.

## Description

### CROSS REFERENCE TO RELATED APPLICATIONS

This application claims priority to International Patent Application No. PCT/CN2023/136558, filed on December 5, 2023, the entire contents of which are hereby incorporated by reference.

### TECHNICAL FIELD

The present disclosure relates to the technical field of electronic devices, and in particular, to an acoustic output device.

### BACKGROUND

The earphones can be worn by a user for audio listening. Accordingly, the user may listen to sounds both during activities such as running and during periods of non-activity. However, in certain scenarios, the user may notice that the acoustic performance of the earphones during activites is inferior to that during non-activity periods.

### SUMMARY

The present disclosure provides an acoustic output device comprising a housing and an air conduction driver. The air conduction driver is disposed within the housing, the housing includes a first acoustic cavity and a second acoustic cavity, the first acoustic cavity and the second acoustic cavity are located on two sides of a diaphragm of the air conduction driver, respectively. The housing is provided with a sound outlet hole, a first pressure relief hole, and a second pressure relief hole. The sound outlet hole is in communication with the first acoustic cavity, and the first pressure relief hole and the second pressure relief hole are in fluid communication with the second acoustic cavity.

The housing defines a first direction, a second direction, and a third direction that are orthogonal to each other, the housing includes a first housing wall and a second housing wall arranged at intervals in the first direction, and the housing further includes a third housing wall connecting the first housing wall and the second housing wall. The first pressure relief hole is disposed on the third housing wall, and the second pressure relief hole is disposed on the second housing wall.

In a wearing state, the first housing wall faces toward a head of a user, the second housing wall is arranged at a side of the first housing wall opposite to the head of the user, and the third housing wall is located on a side of the housing opposite to a crown of the head of the user in the third direction.

In the present disclosure, the provision of the first pressure relief hole and the second pressure relief hole can enable the second pressure relief hole to assist in enhancing the acoustic performance of the acoustic output device when the first pressure relief hole is affected. In certain scenarios, the present disclosure can at least improve the degradation of acoustic performance that tends to occur when the first pressure relief hole is covered by the user's sweat during a physical activity.

### BRIEF DESCRIPTION OF THE DRAWINGS

To more clearly illustrate the technical solutions in the embodiments of the present disclosure, the accompanying drawings to be used in the description of the embodiments will be briefly introduced below, and it will be obvious that the accompanying drawings in the following description are only some of the embodiments of the present disclosure, and other accompanying drawings can be obtained according to these drawings for those skilled in the art without creative labor.
FIG. 1 is a schematic diagram illustrating an exemplary structure of an acoustic output device according to embodiments of the present disclosure;
FIG. 2 is a schematic diagram illustrating a front profile of an ear of a user according to embodiments of the present disclosure;
FIG. 3 is a schematic diagram illustrating an exemplary structure of a core assembly shown in FIG. 1 according to embodiments of the present disclosure;
FIG. 4 is a schematic diagram illustrating an exemplary exploded view of the core assembly shown in FIG. 3 according to embodiments of the present disclosure;
FIG. 5 is a schematic diagram illustrating a second pressure relief hole shwon in FIG. 3 according to embodiments of the present disclosure;
FIG. 6 is a schematic diagram illustrating an exemplary structure of a portion of a housing shown in FIG. 4 according to embodiments of the present disclosure;
FIG. 7 is a schematic diagram illustrating an exemplary structure of a portion of a mesh assembly shown in FIG. 6 according to embodiments of the present disclosure;
FIG. 8 is a schematic diagram illustrating an exemplary cross-sectional view of the portion of the mesh assembly shown in FIG. 7 according to embodiments of the present disclosure; and
FIG. 9 is a schematic diagram illustrating an exemplary structure of an inserting block shown in FIG. 7 according to embodiments of the present disclosure.

### DETAILED DESCRIPTION

The present disclosure is described in further detail below in conjunction with the accompanying drawings and embodiments. In particular, it is noted that the following embodiments are only used to illustrate the present disclosure, but do not limit the scope of the present disclosure. Similarly, the following embodiments are only part of the embodiments of the present disclosure rather than all of the embodiments, and all other embodiments obtained by those skilled in the art without creative labor fall within the scope of protection of the present disclosure.

References to "embodiments" in the present disclosure imply that particular features, structures, or characteristics described in conjunction with the embodiments may be included in at least one embodiment of the present disclosure. It is understood by those skilled in the art, both explicitly and implicitly, that the embodiments described in the present disclosure may be combined with other embodiments.

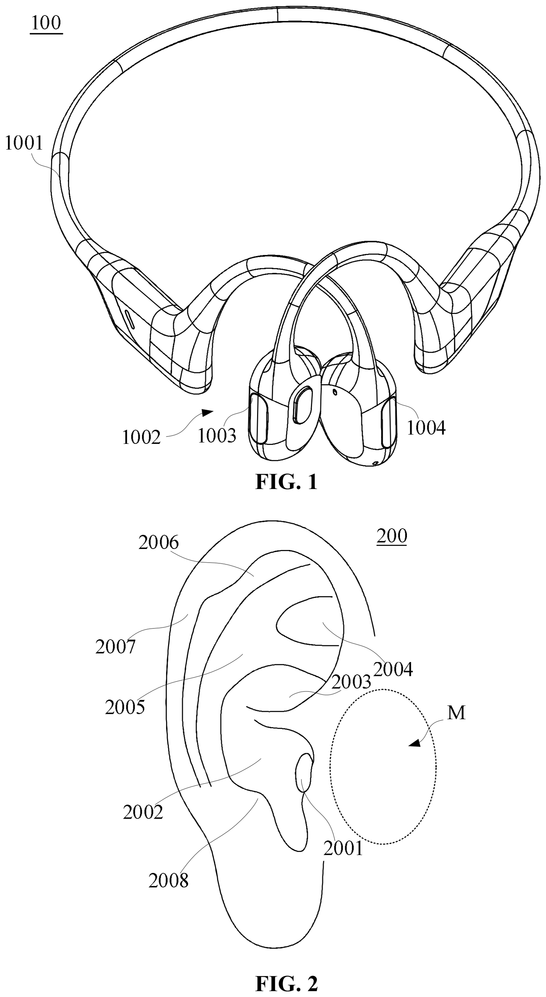

Referring to FIG. 1, FIG. 1 is a schematic diagram illustrating an exemplary structure of an acoustic output device according to embodiments of the present disclosure. An acoustic output device 100 may be used as a sound source for outputting sounds such as an air-conduction sound and a bone-conduction sound. The acoustic output device 100 may be worn on a head of a user and may be at least partially positioned adjacent to an ear of the user, such that the sounds may be transmitted to the ear of the user to enable the user to listen. In some embodiments, the acoustic output device 100 is referred to as "earphones". In some embodiments, the acoustic output device 100 further incorporates other functions, such as picking up sounds, displaying images, or the like, which will not be described in detail herein. In some embodiments, the acoustic output device 100 is configured to drive an air load to produce the air-conduction sound, and is further configured to drive a physical load (e.g., the acoustic output device 100, user tissues, bones, etc.) to produce the bone-conduction sound.

The acoustic output device 100 may include a wearing member 1001 and a core assembly 1002 connected to the wearing member 1001. The wearing member 1001 cooperates with the core assembly 1002 to wear the core assembly 1002 on the head of the user.

The wearing member 1001 may be arranged to encircle the head of the user, or may be hung on the head of the user so as to be worn on the head. The wearing member 1001 may also be hung on the ears of the user. In some embodiments, the wearing member 1001 may be hung only on the ears of the user, and thus the wearing member 1001 may be referred to as an "ear hook". The main function of the wearing member 1001 is to cooperate with the core assembly 1002. Accordingly, the present disclosure does not impose limitations on the specific form of the wearing member 1001, as long as it is capable of cooperating with the core assembly 1002 to enable the core assembly 1002 to be worn on the head of the user.

The core assembly 1002 serves as a structure for implementing the main function of the acoustic output device 100. For example, the core assembly 1002 is configured to push an air load to produce the air-conduction sound. As another example, the core assembly 1002 is configured to push a physical load (e.g., the core assembly 1002, user tissues, bones, etc.) to produce the bone-conduction sound. For example, the core assembly 1002 is configured to implement other functions such as picking up sounds, displaying images, or the like, which will not be described in detail herein.

In some embodiments, the core assembly 1002 may push the air load to produce the air-conduction sound without contacting the user or in contact with the user. In some embodiments, when pushing the physical load to produce the bone-conduction sound, the core assembly 1002 may contact the user.

The core assembly 1002 may be worn on the head of the user through the wearing member 1001. The wearing member 1001 may be replaced with other structures, such that the core assembly 1002 is worn on the head of the user through other structures and/or other wearing manners, which will not be described in detail herein.

Referring to FIG. 2, FIG. 2 is a schematic diagram illustrating a front profile of an ear of a user according to embodiments of the present disclosure. An ear 200 may include an external ear canal 2001, a concha cavity 2002, a cymba conchae 2003, a triangular fossa 2004, an antihelix 2005, a scaphoid fossa 2006, a helix 2007, an antitragus 2008, or the like. The external ear canal 2001 has a certain depth and extends to the tympanic membrane. However, for the sake of description, unless otherwise specified, the external ear canal 2001 refers to an ear hole of the ear 200. In addition, physiological parts such as the concha cavity 2002, the cymba conchae 2003, the triangular fossa 2004, or the like, may also have a certain volume and depth. The concha cavity 2002 may be directly connected to the external ear canal 2001, i.e., it may be regarded as the ear hole located at a bottom of the concha cavity 2002. In FIG. 2, the head of the user includes a face region M that is adjacent to the ear 200. In some embodiments, the face region M is located on the front side of the ear 200. It should be understood that the face region M may also be divided and adjusted on the face of the user as desired by those skilled in the art.

It should be noted that in the fields of medicine and anatomy, the human body can be defined by three fundamental planes including a sagittal plane, a coronal plane, and a horizontal plane, as well as three fundamental axes including a sagittal axis, a coronal axis, and a vertical axis. The sagittal plane refers to a vertical plane cutting in the anteroposterior direction, perpendicular to the ground, which divides the body into left and right portions. The coronal plane refers to a vertical plane cutting in the mediolateral direction, perpendicular to the ground, which divides the body into front and rear portions. The horizontal plane refers to a transverse plane cutting parallel to the ground in the superior-inferior direction, which divides the body into upper and lower portions. The sagittal axis refers to an axis in the nteroposterior direction and perpendicular to the coronal plane. The coronal axis refers to an axis in the mediolateral direction and perpendicular to the sagittal plane. The perpendicular axis refers to an axis in the superior-inferior direction and perpendicular to the horizontal plane. The term "front side of the ear" as described in the present disclosure is a concept relative to "rear side of the ear", where the former refers to a side of the ear facing the face, and the latter refers to a side of the ear opposite to the face. As shown in FIG. 2, the ear 200 of the body is viewed in the direction where the coronal axis is located.

Referring to FIG. 1 and FIG. 2, the acoustic output device 100 may be in a wearing state when worn on the head of the user. When the acoustic output device 100 is in the wearing state, the core assembly 1002 may be disposed adjacent to the ear 200, the core assembly 1002 may be in contact with the head of the user, the core assembly 1002 may be further in contact with the ear 200, and the core assembly 1002 may be in contact with the face of the user.

In some embodiments, when the acoustic output device 100 is in the wearing state, the core assembly 1002 is disposed in the face region M that is adjacent to the ear 200, so as to be closer to the ear 200. In some embodiments, the core assembly 1002 is in contact with the facial skin at the face region M of the user for stable wear. In some embodiments, the core assembly 1002 is in contact with the facial skin at the face region M, and is configured to push a physical load (e.g., the core assembly 1002, user tissues, bones, etc.) to produce the bone-conduction sound.

Referring to FIG. 1, a count of core assemblies 1002 may be two, such as a first core assembly 1003 and a second core assembly 1004. The first core assembly 1003 may be worn corresponding to the ear 200 on the left side of the user, and the second core assembly 1004 may be worn corresponding to the ear 200 on the right side of the user. In some embodiments, one core assembly 1002 is provided, such as one of the first core assembly 1003 and the second core assembly 1004 is omitted.

In some embodiments, the first core assembly 1003 may be worn corresponding to the ear 200 on the left side of the user and is disposed at the face region M that is adjacent to the ear 200 on the left side, and the second core assembly 1004 may be worn corresponding to the ear 200 on the right side of the user and is disposed at the face region M that is adjacent to the ear 200 on the right side.

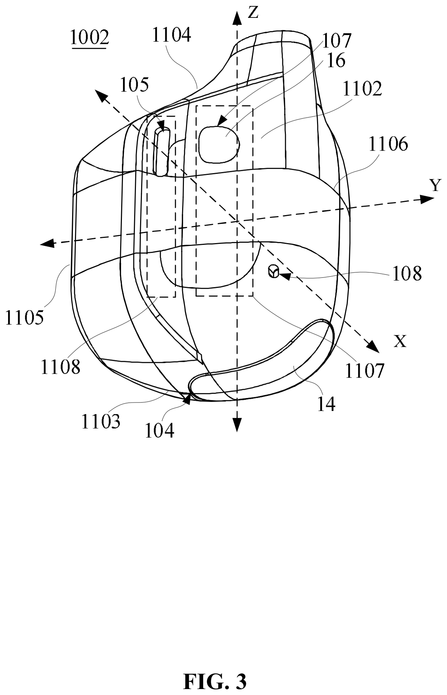

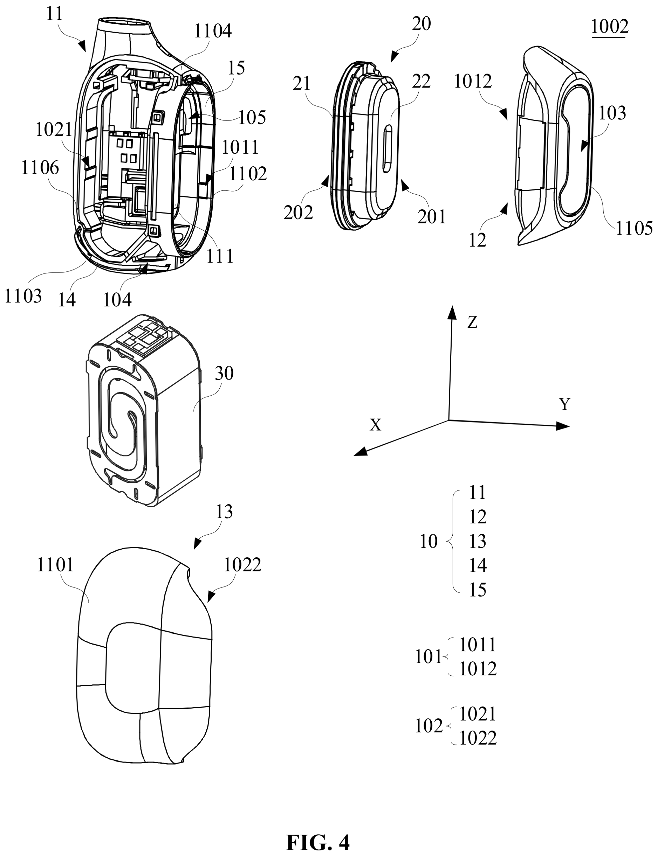

Referring to FIG. 3 and FIG. 4, FIG. 3 is a schematic diagram illustrating an exemplary structure of the core assembly 1002 shown in FIG. 1 according to embodiments of the present disclosure. FIG. 4 is a schematic diagram illustrating an exploded view of the core assembly 1002 shown in FIG. 3 according to embodiments of the present disclosure. The core assembly 1002 may include a housing 10 and an air conduction driver 20 carried by the housing 10. The housing 10 is configured to carry the air conduction driver 20. The air conduction driver 20 is configured to produce the air-conduction sound to be transmitted to the ear 200 of the user.

In some embodiments, the air conduction driver 20 includes a diaphragm 21. When vibrating, the diaphragm 21 causes air vibrations, thereby driving an air load to produce sounds in accordance with the principle of air vibration, and transmitting the sounds to the ear 200 of the user.

In some embodiments, the housing 10 includes a first acoustic cavity 201 and a second acoustic cavity 202, and the first acoustic cavity 201 and the second acoustic cavity 202 are located on two sides of the diaphragm 21 of the air conduction driver 20, respectively.

In some embodiments, the first acoustic cavity 201 is referred to as a "rear cavity" and the second acoustic cavity 202 is referred to as a "front cavity". In some embodiments, the "front cavity" and the "rear cavity" are differentiated as follows: the "front cavity" is located on a side of the diaphragm 21 that is opposite to a magnetic circuit system 22, and the "rear cavity" is located on a side of the diaphragm 21 that is adjacent to the magnetic circuit system 22. The distinction between the "front cavity" and the "rear cavity" can also be made on the basis of the technology in the field.

In some embodiments, the air conduction driver 20 cooperates with the housing 10 to form the first acoustic cavity 201 and the second acoustic cavity 202 located on the two sides of the diaphragm 21 of the air conduction driver 20, respectively.

In some embodiments, the first acoustic cavity 201 and the second acoustic cavity 202 are in communication with each other, which is advantageous for reducing the resistance experienced by the diaphragm 21 of the air conduction driver 20 during a vibration. In some embodiments, the first acoustic cavity 201 and the second acoustic cavity 202 are not in communication with each other, so as to separate the two acoustic cavities and reduce an interference between sounds. Specifically, the first acoustic cavity 201 and the second acoustic cavity 202 may be in communication or not in communication with each other according to the needs of those skilled in the art.

In some embodiments, the magnetic circuit system 22 is configured to drive the diaphragm 21 to vibrate, i.e., the magnetic circuit system 22 is a portion of the air conduction driver 20. Specifically, the process by which the diaphragm 21 vibrates or the magnetic circuit system 22 drives the diaphragm 21 to vibrate may be realized based on conventional art in the field, which will not be described in detail herein.

In some embodiments, the housing 10 is provided with a sound outlet hole 103 in communication with the first acoustic cavity 201, and the sound outlet hole 103 is configured to transmit the air-conduction sound produced by the air conduction driver 20 from the first acoustic cavity 201 to an exterior of the housing 10.

In some embodiments, the housing 10 is provided with a first pressure relief hole 104 in communication with the second acoustic cavity 202. The first pressure relief hole 104 may connect the second acoustic cavity 202 with an external environment (the exterior of the housing 10), such that air can flow between the second acoustic cavity 202 and the external environment, thereby reducing the resistance experienced by the diaphragm 21 of the air conduction driver 20 during a vibration. In some embodiments, the first pressure relief hole 104 cooperates with the sound outlet hole 103 to reduce a far-field sound leakage of the acoustic output device 100.

In some embodiments, the housing 10 includes a mesh assembly 14 disposed at the first pressure relief hole 104. In some embodiments, the mesh assembly 14 is configured to adjust the sound emitted by the air conduction driver 20, thereby improving the acoustic performance of the acoustic output device 100. In some embodiments, the mesh assembly 14 is dustproof.

In some embodiments, the user may wear the acoustic output device 100 during activities such as running or during non-activity periods. Studies have shown that the acoustic output device 100 may occasionally exhibit inferior acoustic performance during activities as compared with non-activity periods. Further studies have shown that, during activities, the user produces a large amount of sweat, which may accumulate at the first pressure relief hole 104, e.g., on the mesh assembly 14. This accumulation reduces the effective opening area of the first pressure relief hole 104, thereby increasing the resistance experienced by the diaphragm 21 of the air conduction driver 20 during the vibration, and consequently degrading the acoustic performance. Correspondingly, this accumulation also increases the far-field sound leakage of the acoustic output device 100.

In some embodiments, according to the effect of sweat on the first pressure relief hole 104, the housing 10 is provided with a second pressure relief hole 105 that is in fluid communication with the second acoustic cavity 202. When the first pressure relief hole 104 is affected by sweat, the second pressure relief hole 105 may assist the first pressure relief hole 104 by allowing air to enter and exit the second acoustic cavity 202 through the second pressure relief hole 105, thereby compensating for the insufficiency caused by the influence of sweat on the first pressure relief hole 104. The second pressure relief hole 105 may also reduce the resistance experienced by the diaphragm 21 of the air conduction driver 20 during vibration, and may further cooperate with the sound outlet hole 103 to reduce the far-field sound leakage of the acoustic output device 100.

It is understandable that, when the acoustic output device 100 is in the wearing state, the first pressure relief hole 104 may not only be blocked by sweat, but may also be blocked by dust, oil stains, water, or other obstructions. The provision of the second pressure relief hole 105 can compensate for the deficiencies caused by the blockage of the first pressure relief hole 104, thereby reducing the impact on the acoustic performance of the acoustic output device 100 when the first pressure relief hole 104 is blocked.

In some embodiments, the housing 10 defines a first direction X, a second direction Y, and a third direction Z that are orthogonal to each other. In the wearing state, the first direction X may be a direction of the coronal axis, or a direction at an angle to the coronal axis. In the wearing state, the second direction Y may be a direction of the sagittal axis, or a direction at an angle to the sagittal axis. In the wearing state, the third direction Z may be a direction of the vertical axis, or a direction at an angle to the vertical axis.

In some embodiments, the housing 10 includes a first housing wall 1101 and a second housing wall 1102 arranged at intervals in the first direction X. In the wearing state, the first housing wall 1101 may face toward the head of the user, and the second housing wall 1102 is arranged at a side of the first housing wall 1101 that is opposite to the head of the user.

In some embodiments, in the wearing state, the first housing wall 1101 faces toward the face region M on the front side of the ear 200 of the user, and the second housing wall 1102 is arranged at a side of the first housing wall 1101 that is opposite to the face region M. In some embodiments, the first housing wall 1101 is in contact with the facial skin at the face region M of the user.

In some embodiments, in the wearing state, the sound outlet hole 103 is disposed on a side of the housing 10 that faces toward the ear 200. In some embodiments, in the wearing state, the sound outlet hole 103 is disposed on the side of the housing 10 that faces toward the ear 200 in the second direction Y.

In some embodiments, the housing 10 further includes a third housing wall 1103 connecting the first housing wall 1101 and the second housing wall 1102. In some embodiments, the first pressure relief hole 104 is disposed on the third housing wall 1103.

In the wearing state, the third housing wall 1103 may be disposed on a side of the housing 10 that is opposite to a crown of the head of the user in the third direction Z, which in turn causes the first pressure relief hole 104 to be disposed at a more downward position in the vertical axis. When sweat flows over the surface of the housing 10, at least a portion of the sweat flows downward in the vertical axis under the action of gravity and accumulates at the first pressure relief hole 104, thereby posing a risk of blocking the first pressure relief hole 104. Accordingly, it is necessary to provide the second pressure relief hole 105 to assist the first pressure relief hole 104 in pressure relief. The second pressure relief hole 105 facilitates air to enter and exit the second acoustic cavity 202, thereby compensating for the deficiency resulting from the first pressure relief hole 104 being affected by sweat.

Additionally, the first pressure relief hole 104 is favorable for reducing the leakage of sound waves propagating through the first pressure relief hole 104 that may be audible to the user.

In some embodiments, the second pressure relief hole 105 is disposed on the second housing wall 1102 differently from the first pressure relief hole 104, which reduces the probability of both the first pressure relief hole 104 and the second pressure relief hole 105 being blocked simultaneously.

In the wearing state, the second housing wall 1102 is arranged at the side of the first housing wall 1101 that is opposite to the head of the user, and thus does not contact the facial skin at the head of the user, thereby greatly reducing the likelihood of sweat on the user's skin flowing toward the second pressure relief hole 105. The second pressure relief hole 105 may also be disposed on other housing walls of the housing 10 as desired.

In some embodiments, by providing both the first pressure relief hole 104 and the second pressure relief hole 105, the generation of standing waves within the second acoustic cavity 202 can be suppressed, thereby improving the sound quality of the acoustic output device 100.

In some embodiments, the housing 10 further includes a fourth housing wall 1104 connecting the first housing wall 1101 and the second housing wall 1102. The fourth housing wall 1104 may be disposed opposite the third housing wall 1103 in the third direction Z.

In some embodiments, the second pressure relief hole 105 is located closer to the fourth housing wall 1104 in the third direction Z than the third housing wall 1103, which allows the second pressure relief hole 105 to be located away from the first pressure relief hole 104, thereby lowering the probability that the pressure relief hole 104 and the second pressure relief hole 105 are blocked at the same time.

In the wearing state, the fourth housing wall 1104 is disposed on a side of the housing 10 facing toward the crown of the head of the user in the third direction Z, and the second pressure relief hole 105 is located closer to the crown of the head of the user, which is conducive to reducing the impact of the sound wave propagated through the second pressure relief hole 105 on the output performance of the acoustic output device 100.

In some embodiments, the second pressure relief hole 105 is arranged in an elongated shape, which allows efficient utilization of the space of the housing 10 and enables an arrangement of the second pressure relief hole 105 within a very limited space.

In some embodiments, an opening area of the second pressure relief hole 105 is not less than 4 mm². Studies have shown that, if the opening area of the second pressure relief hole 105 is less than 4 mm², when the first pressure relief hole 104 is blocked, the second acoustic cavity 202 releases pressure through the second pressure relief hole 105, and the pressure relief effect is inferior compared to that achieved solely through the first pressure relief hole 104, resulting in an impact on the acoustic performance. In the present disclosure, by setting the opening area of the second pressure relief hole 105 to be not less than 4 mm², when the first pressure relief hole 104 is blocked, the second acoustic cavity may can release pressure through the second pressure relief hole 105, such that the output performance of the acoustic output device 100 is minimally affected or nearly unaffected. Such an arrangement is advantageous for reducing the impact of the blockage of the first pressure relief hole 104 on the output performance of the acoustic output device 100. In some embodiments, the opening area of the second pressure relief hole 105 may be 4 mm², 4.5 mm², 5 mm², 5.5 mm², 6 mm², 6.5 mm², 7 mm², 7.5 mm², or 8 mm², which is conducive to minimizing the impact of the blockage of the first pressure relief hole 104 on the output performance of the acoustic output device 100.

In some embodiments, the opening area of the second pressure relief hole 105 is smaller than an opening area of the first pressure relief hole 104. In some embodiments, the probability of the first pressure relief hole 104 being fully blocked is small, which in turn results in the opening area of the second pressure relief hole 105 being smaller than the opening area of the first pressure relief hole 104. In some embodiments, the second pressure relief hole 105 serves as an acoustic hole to assist the first pressure relief hole 104, which in turn allows the opening area of the second pressure relief hole 105 to be smaller than the opening area of the first pressure relief hole 104. In some embodiments, to reduce the impact of the simultaneous operation of the first pressure relief hole 104 and the second pressure relief hole 105 on the output performance of the acoustic output device 100, the opening area of the second pressure relief hole 105 is smaller than the opening area of the first pressure relief hole 104.

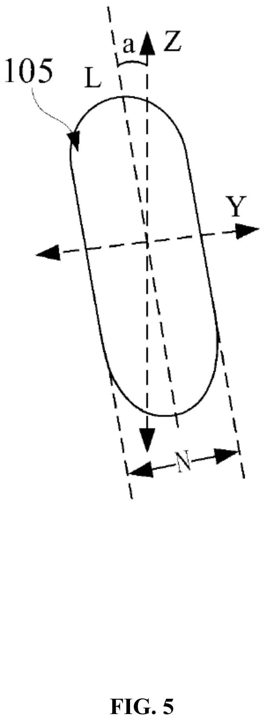

Referring to FIG. 5, FIG. 5 is a schematic diagram illustrating the second pressure relief hole 105 shown in FIG. 3 according to embodiments of the present disclosure. In some embodiments, the second pressure relief hole 105 is arranged in an inclined manner, which is conducive to increasing the opening area of the second pressure relief hole 105 in a limited space, enhancing its effect in assisting the first pressure relief hole 104, and thereby reducing the impact on the output performance of the acoustic output device 100 while assisting.

In some embodiments, an angle between a length direction of the second pressure relief hole 105 and the third direction Z is defined as an angle a, with the angle α being no greater than 15 degrees. In some embodiments, the angle a is in a range of 5 degrees to 10 degrees. In some embodiments, the angle a is 5 degrees, 6 degrees, 7 degrees, 8 degrees, 9 degrees, 10 degrees, 11 degrees, 12 degrees, 13 degrees, 14 degrees, or 15 degrees.

In some embodiments, a width N of the second pressure relief hole 105 is not greater than 1 mm, which allows for full utilization of the space of the housing 10 and improves space utilization. In some embodiments, the width N of the second pressure relief hole 105 is not greater than 0.8 mm. In some embodiments, the width N of the second pressure relief hole 105 is 0.3 mm, 0.4 mm, 0.5 mm, 0.6 mm, 0.7 mm, 0.8 mm, 0.9 mm, or 1 mm.

Referring to FIG. 3, the core assembly 1002 may further include a button 16 mounted on the housing 10, e.g., on the second housing wall 1102. The button 16 may be configured to control the acoustic output device 100 for a proper operation. In some embodiments, the button 16 is configured to control the air conduction driver 20. The button 16 may be a press-type button, a touch-type button, or a button of other types, which will not be described in detail herein.

In some embodiments, the button 16 and the second pressure relief hole 105 are at least partially overlapped in the second direction Y to improve the aesthetic appearance of the acoustic output device 100 through the cooperation between the button 16 and the second pressure relief hole 105.

In some embodiments, the positioning of the button 16 is realized through the second pressure relief hole 105, enabling the user to quickly sense the position of the button 16 through the second pressure relief hole 105, thereby facilitating an operation of the user. In some embodiments, the button 16 and the second pressure relief hole 105 are completely overlapped in the second direction Y. In some embodiments, the cooperation between the button 16 and the second pressure relief hole 105 forms an "!" -shaped pattern on the second housing wall 1102, thereby improving the aesthetic appearance of the acoustic output device 100.

In some embodiments, in the wearing state, the second pressure relief hole 105 is located closer to the ear 200 in the second direction Y than the button 16, which makes it easier for the user to touch the button 16, and additionally leaves more space for mounting the button 16 on the second housing wall 1102.

Referring to FIG. 3, in some embodiments, the second housing wall 1102 is further provided with a button hole 107. The button 16 may be disposed within the button hole 107.

In some embodiments, the button hole 107 and the second pressure relief hole 105 are at least partially overlapped in the second direction Y. Through the cooperation between the button hole 107 and the second pressure relief hole 105 and/or the cooperation between the button 16 and the second pressure relief hole 105, the aesthetic appearance of the acoustic output device 100 can be improved. In some embodiments, the button hole 107 and the second pressure relief hole 105 are completely overlapped in the second direction Y. In some embodiments, the cooperation between the button hole 107 and the second pressure relief hole 105 forms an "!"-shaped pattern on the second housing wall 1102, thereby improving the aesthetic appearance of the acoustic output device 100.

In some embodiments, in the wearing state, the second pressure relief hole 105 is located closer to the ear 200 than the button hole 107 is in the second direction Y, which makes it easier for the user to touch the button 16.

In some embodiments, the second housing wall 1102 is provided with a microphone hole 108. In turn, the microphone hole 108 may cooperate with a microphone disposed within the core assembly 1002 so that the microphone can receive sounds from the outside through the microphone hole 108. In some embodiments, in the second direction Y, the microphone hole 108 is disposed on a side of the second pressure relief hole 105 away from the sound outlet hole 103. The microphone hole 108 and the second pressure relief hole 105 are located close to opposite edges of the second housing wall 1102, respectively. Therefore, the microphone hole 108 is located away from the second pressure relief hole 105, which is advantageous for reducing the impact of sounds emitted from the second pressure relief hole 105 on the microphone within the core assembly 1002, thereby decreasing the likelihood of echo generation.

In some embodiments, in the third direction Z, the microphone hole 108 is disposed at an intermediate position between the first pressure relief hole 104 and the second pressure relief hole 105, which is favorable to take into account the impact of the sounds output from the first pressure relief hole 104 and the second pressure relief hole 105 on the microphone and reduce the likelihood of echo generation.

Referring to FIG. 3 and FIG. 4, in the second direction Y, the second pressure relief hole 105 is located closer to the sound outlet hole 103 than the button hole 107 or the button 16. In turn, a first region 1107 and a second region 1108 are provided on an outer wall surface of the second housing wall 1102. The button hole 107 or the button 16 is disposed in the first region 1107, and the second pressure relief hole 105 is disposed in the second region 1108.

To avoid the second pressure relief hole 105 being too close to the sound outlet hole 103, the second region 1108 is bent and connected to the first region 1107 and extends, in the first direction X, relative to the first region 1107 toward the side opposite the facial skin to form a region that reflects leaked sound or guides the leaked sound. When sound waves propagated through the second pressure relief hole 105 produce a sound leakage, the second region 1108 guides and/or reflects the leaked sound, thereby preventing the sound waves propagated through the second pressure relief hole 105 from being audible to the user. In addition, the impact of the second pressure relief hole 105 being too close to the sound outlet hole 103 can be minimized. Furthermore, the formation of the second region 1108 is a result of the morphological limitation of the housing 10 itself, and the provision of the second pressure relief hole 105 in the second region 1108 can also fully utilize the second region 1108, thereby improving the space utilization.

In the wearing state, the second region 1108 is located closer to the ear 200 in the second direction Y than the first region 1107. The second region 1108 is disposed on a side of the first region 1107 facing toward the sound outlet hole 103.

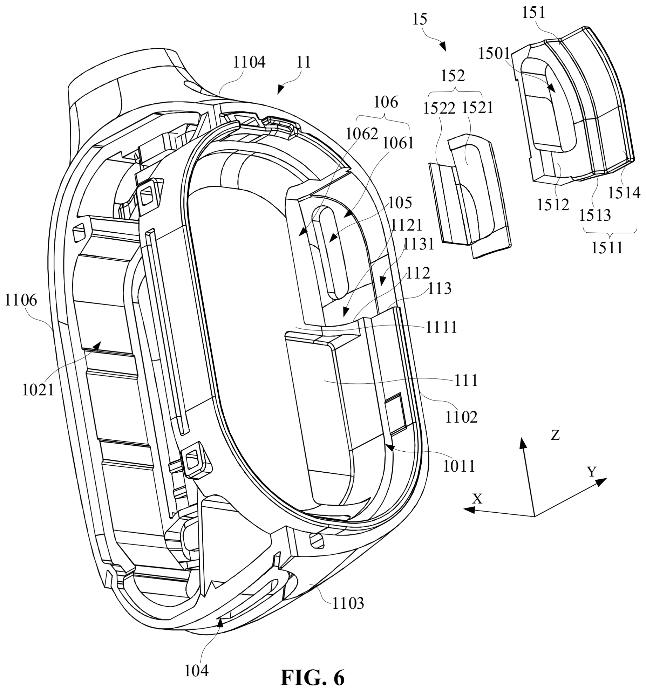

Referring to FIG. 6, FIG. 6 is a schematic diagram illustrating an exemplary structure of a portion of the housing 10 shown in FIG. 4 according to embodiments of the present disclosure. The housing 10 may include a mesh assembly 15 that covers the second pressure relief hole 105. In some embodiments, the mesh assembly 15 adjusts sounds emitted by the air conduction driver 20 to improve the acoustic performance of the acoustic output device 100. In some embodiments, the mesh assembly 15 is dustproof and/or waterproof.

The mesh assembly 15 may include a mesh 152. The mesh 152 may be disposed on the second housing wall 1102 and cover the second pressure relief hole 105. Sounds produced by the air conduction driver 20 within the second acoustic cavity 202 may be propagated outside of the housing 10 through the second pressure relief hole 105. The sound may pass through the mesh 152. In some embodiments, the mesh 152 may be a screen mesh or other type of sound-blocking mesh.

Referring to FIG. 6, an embedding groove 106 is provided on an inner side of the second housing wall 1102. The provision of the embedding groove 106 expands the space within the housing 10. The embedding groove 106 may be in communication with the second pressure relief hole 105. In some embodiments, the embedding groove 106 may include a recess 1061. The recess 1061 provides clearance for structures within the housing 10 and may be in communication with the second pressure relief hole 105.

The mesh assembly 15 may be disposed within the embedding groove 106, such as within the recess 1061, to cover the second pressure relief hole 105. The mesh assembly 15 may be disposed within the embedding groove 106, such as within the recess 1061, which can reduce the occupancy of the space within the housing 10. In some embodiments, the mesh assembly 15 may adjust the sounds emitted by the air conduction driver 20 to improve the acoustic performance of the acoustic output device 100. In some embodiments, the mesh assembly 15 is dustproof and/or waterproof.

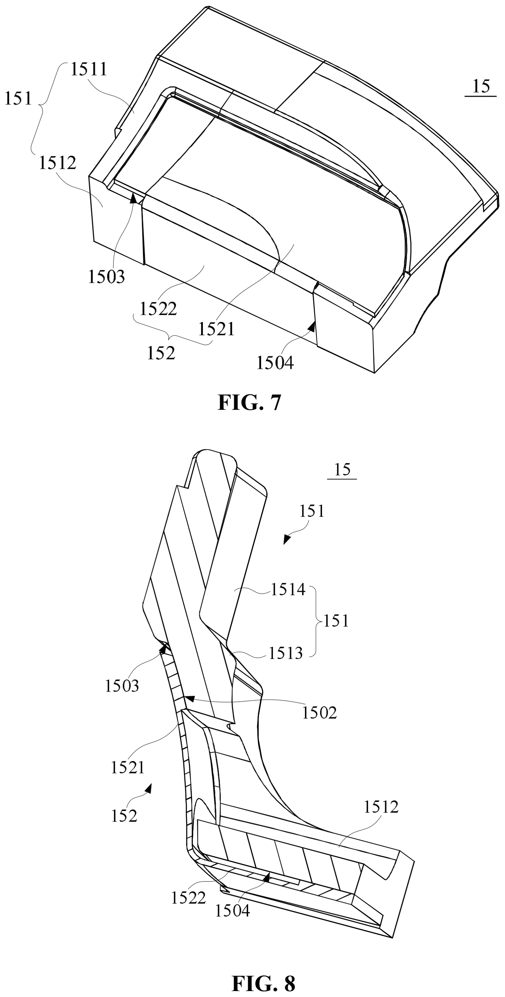

Referring to FIG. 6, FIG. 7, and FIG. 8, FIG. 7 is a schematic diagram illustrating an exemplary structure of a portion of the mesh assembly 15 shown in FIG. 6 according to embodiments of the present disclosure, and FIG. 8 is a schematic diagram illustrating an exemplary cross-sectional view of the portion of the mesh assembly 15 shown in FIG. 7 according to embodiments of the present disclosure. The mesh assembly 15 may include an inserting block 151. The inserting block 151 may be inserted into the embedding groove 106, such as into the recess 1061, and fixed relative to the housing 10 (e.g., the housing wall(s)). The mesh 152 may be disposed between the inserting block 151 and the second housing wall 1102, and cover the second pressure relief hole 105. The inserting block 151 may support the mesh 152, realize the installation of the mesh 152 at the second pressure relief hole 105, and also ensure the stability of the mesh 152. Additionally, the cooperation between the inserting block 151 and the mesh 152 facilitates the assembly and fixation of the housing 10, making the housing 10 easy to process.

In some embodiments, the inserting block 151 is provided with a sound guide hole 1501. The sound guide hole 1501 and the second pressure relief hole 105 may be at least partially overlapped when the inserting block 151 is inserted into the embedding groove 106. In turn, the sound guide hole 1501 and the second pressure relief hole 105 may be in communication with each other, so that the second acoustic cavity 202, the sound guide hole 1501, and the second pressure relief hole 105 may be in communication with each other. Therefore, the sound produced by the air conduction driver 20 within the second acoustic cavity 202 may be propagated outside of the housing 10 through the sound guide hole 1501 and the second pressure relief hole 105, and the sound may pass through the mesh 152.

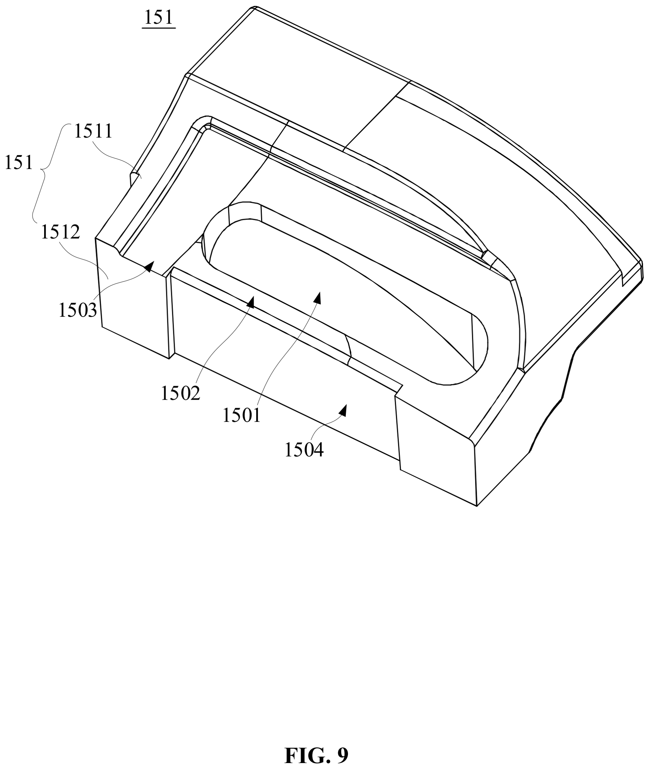

Referring to FIG. 8 and FIG. 9, FIG. 9 is a schematic diagram illustrating an exemplary structure of the inserting block 151 shown in FIG. 7 according to embodiments of the present disclosure. An annular abutting region 1502 may be formed between the inserting block 151 and an inner wall surface of the second housing wall 1102 around a periphery of the sound guide hole 1501 and the second pressure relief hole 105. The annular abutting region 1502 may accommodate the mesh 152 such that the inserting block 151 is clamped with the second housing wall 1102 to fix the mesh 152.

Referring to FIG. 6, FIG. 7, and FIG. 8, the mesh 152 may include a mesh body 1521 and an extension portion 1522. The mesh body 1521 is bent and connected to the extension portion 1522 to increase the overall area of the mesh 152 for easy assembly and fixation with the inserting block 151.

The housing 10 is further provided with a support surface 1111 that supports the inserting block 151 in the second direction Y. The mesh body 1521 is disposed between the inserting block 151 and the inner wall surface of the second housing wall 1102. The extension portion 1522 may be disposed between the inserting block 151 and the support surface 1111.

Referring to FIG. 7, FIG. 8, and FIG. 9, the inserting block 151 is provided with a first accommodation groove 1503 and a second accommodation groove 1504 to accommodate and fix the mesh 152. The provision of the first accommodation groove 1503 and the second accommodation groove 1504 allows the inserting block 151 to be located closer to the second housing wall 1102 and the support surface 1111, thereby improving space utilization of the housing 10.

In some embodiments, the first accommodation groove 1503 is disposed on a side of the inserting block 151 facing toward the inner wall surface of the second housing wall 1102. In some embodiments, the mesh body 1521 is accommodated and fixed within the first accommodation groove 1503.

In some embodiments, the second accommodation groove 1504 is disposed on a side of the inserting block 151 facing toward the support surface 1111. In some embodiments, the extension portion 1522 is accommodated and fixed within the second accommodation groove 1504.

Referring to FIG. 6, a first flange 112 for supporting the air conduction driver 20 is disposed on the inner wall surface of the second housing wall 1102. In some embodiments, the embedding groove 106 forms a first notch 1121 on the first flange 112, and the inserting block 151 is provided with a first filling portion 1513 for filling the first notch 1121. At least a portion of the inserting block 151 may be disposed between the air conduction driver 20 and the second housing wall 1102 to support the air conduction driver 20. The first notch 1121 can facilitate the assembly and fixation of the inserting block 151.

In some embodiments, the first flange 112 may extend to the first housing wall 1101, to the third housing wall 1103, and/or to the fourth housing wall 1104.

Referring to FIG. 4, the housing 10 may include a fifth housing wall 1105 and a sixth housing wall 1106 arranged at intervals in the second direction Y. Both the fifth housing wall 1105 and the sixth housing wall 1106 are connected to the first housing wall 1101, the second housing wall 1102, the third housing wall 1103, and the fourth housing wall 1104. In the second direction Y, the fifth housing wall 1105 may be located closer to the ear 200 than the sixth housing wall 1106. In some embodiments, the sound outlet hole 103 is disposed on the fifth housing wall 1105.

In some embodiments, the first housing wall 1101, the second housing wall 1102, the third housing wall 1103, the fourth housing wall 1104, the fifth housing wall 1105, and the sixth housing wall 1106 enclose to form the housing 10.

In some embodiments, at least the second housing wall 1102, the third housing wall 1103, the fourth housing wall 1104, and the sixth housing wall 1106 enclose to form a main housing 11. In some embodiments, the fifth housing wall 1105 is detached from the housing 10 to form an independent structure, which is referred to as a cover body 12. In some embodiments, the first housing wall 1101 is detached from the housing 10 to form an independent structure, which is referred to as an assembly housing 13. Furthermore, in some embodiments, the housing 10 includes the main housing 11, the cover body 12, and the assembly housing 13. The main housing 11 may be connected to the cover body 12 in the second direction Y, and may be connected to the assembly housing 13 in the first direction X. In some embodiments, the cover body 12 may also be connected to the assembly housing 13. The main housing 11, the cover body 12, and the assembly housing 13 may be assembled in a manner that facilitates the assembly and the machining of the housing 10.

It will be appreciated that the main housing 11 may not be limited to the second housing wall 1102, the third housing wall 1103, the fourth housing wall 1104, and the sixth housing wall 1106, but may include other components. In some embodiments, the main housing 11 may be structured in other forms. The cover body 12 may not be limited to the fifth housing wall 1105, but may include other housing walls. In some embodiments, the cover body 12 may be structured in other forms. The assembly housing 13 may not be limited to the first housing wall 1101, but may include other housing walls. In some embodiments, the assembly housing 13 may be structured in other forms.

In some embodiments, the support surface 1111 is disposed on the sixth housing wall 1106.

In some embodiments, the microphone hole 108 is disposed at an edge of the second housing wall 1102 close to the sixth housing wall 1106, or at a corner where the second housing wall 1102 is connected to the sixth housing wall 1106, or at a corner where the second housing wall 1102, the third housing wall 1103, and the sixth housing wall 1106 are connected.

In some embodiments, the second pressure relief hole 105 is disposed at an edge of the second housing wall 1102 close to the fifth housing wall 1105, or at an edge of the second housing wall 1102 close to the fourth housing wall 1104. Referring to FIG. 4, the cover body 12 may be disposed on an end surface of the second housing wall 1102. The cover body 12 may be disposed on end surfaces of the first housing wall 1101, the third housing wall 1103, and the fourth housing wall 1104 at the same time. In some embodiments, the cover body 12 may be disposed on the assembly housing 13.

Referring to FIG. 6, a second flange 113 is disposed on the end surface of the second housing wall 1102 for positioning the cover body 12. In some embodiments, the second flange 113 may be connected and fixed to the cover body 12. The embedding groove 106, such as the recess 1061, forms a second notch 1131 on the second flange 113. The inserting block 151 is provided with a second filling portion 1514 for filling the second notch 1131. When the second filling portion 1514 is disposed on the second notch 1131, the second flange 113 cooperates with the cover body 12 for positioning and/or fixing the second filling portion 1514, thereby improving the installation stability of the mesh assembly 15.

In some embodiments, the first filling portion 1513 and the second filling portion 1514 cooperate to fill the embedding groove 106 (e.g., the recess 1061) and form a fixing portion 1511. The fixing portion 1511 may be fixed within the embedding groove 106 (e.g., the recess 1061) by means of adhesive bonding. Simultaneously, the fixing portion 1511 may be positioned and/or fixed to the cover body 12 by the second flange 113.

In some embodiments, the embedding groove 106 forms a positioning recess 1062 on the support surface 1111. The positioning recess 1062 may be in communication with the recess 1061 to cooperate to install the mesh assembly 15. In some embodiments, the inserting block 151 is inserted into the positioning recess 1062. In some embodiments, the positioning recess 1062 positions the inserting block 151, and the second flange 113 positions and/or fixes the inserting block 151 together with the cover body 12, thereby enabling the mesh assembly 15 to be positioned and/or fixed, which enhances the mounting stability of the mesh assembly 15. In some embodiments, the inserting block 151 may include a positioning portion 1512 accommodated within the positioning recess 1062. The positioning portion 1512 may be integrally connected to the fixing portion 1511 to form the inserting block 151.

In some embodiments, the first accommodation groove 1503 is disposed on a side of the inserting block 151 (e.g., the fixing portion 1511) facing toward the inner wall surface of the second housing wall 1102.

In some embodiments, the second accommodation groove 1504 is disposed on a side of the inserting block 151 (e.g., the positioning portion 1512) facing toward the support surface 1111.

In some embodiments, the sound guide hole 1501 is disposed at least on the fixing portion 1511. In some embodiments, the sound guide hole 1501 is partially disposed on the positioning portion 1512.

Referring to FIG. 4 and FIG. 6, the housing 10 further includes a partition wall 111. The partition wall 111 is configured to separate the internal space of the housing 10 into the first accommodation cavity 101 and the second accommodation cavity 102 that are arranged at intervals from each other. After the internal space of the housing 10 is partitioned, it may be divided into separate regions corresponding to different functions of the acoustic output device 100, so as to improve space utilization and reduce a mutual interference between components of different functions. In some embodiments, the first accommodation cavity 101 and the second accommodation cavity 102 are arranged in the second direction Y, and the first accommodation cavity 101 is located closer to the ear 200 than the second accommodation cavity 102. In turn, when the air conduction driver 20 is disposed within the first accommodation cavity 101, the transmission distance of the sound produced by the vibration of the air conduction driver 20 can be shortened, and the sound pressure level of the acoustic output device 100 can be increased.

In some embodiments, the sound outlet hole 103, the first pressure relief hole 104, and the second pressure relief hole 105 are all in fluid communication with the first accommodation cavity 101.

In some embodiments, the first accommodation cavity 101 is enclosed by the partition wall 111, the first housing wall 1101, the second housing wall 1102, the third housing wall 1103, the fourth housing wall 1104, and the fifth housing wall 1105.

In some embodiments, the first accommodation cavity 101 is enclosed by the partition wall 111, the second housing wall 1102, the third housing wall 1103, the fourth housing wall 1104, and the fifth housing wall 1105.

In some embodiments, the first accommodation cavity 101 is formed by a connection of the main housing 11 and the cover body 12.

In some embodiments, the main housing 11 includes a first sub-accommodation cavity 1011, and the cover body 12 includes a second sub-accommodation cavity 1012. When the main housing 11 is connected to the cover body 12, the first sub-accommodation cavity 1011 and the second sub-accommodation cavity 1012 form the first accommodation cavity 101.

In some embodiments, the first acoustic cavity 201 and the second acoustic cavity 202 are disposed within the first accommodation cavity 101. In some embodiments, the first acoustic cavity 201 is disposed on a side of the diaphragm 21 facing toward the fifth housing wall 1105, and the second acoustic cavity 202 is disposed on a side of the diaphragm 21 facing toward the partition wall 111.

In some embodiments, the microphone within the core assembly 1002 is disposed within the second accommodation cavity 102, and the microphone hole 108 is in communication with the second accommodation cavity 102.

In some embodiments, the mesh assembly 15 is disposed within the first accommodation cavity 101. In some embodiments, the support surface 1111 is disposed on the partition wall 111. In turn, in some embodiments, the inserting block 151 (e.g., the positioning portion 1512) abuts against the partition wall 111. In some embodiments, the positioning recess 1062 is disposed on the partition wall 111.

In some embodiments, the second accommodation cavity 102 is enclosed by the partition wall 111, the first housing wall 1101, the second housing wall 1102, the third housing wall 1103, the fourth housing wall 1104, and the sixth housing wall 1106.

In some embodiments, the second accommodation cavity 102 is formed by a connection of the main housing 11 and the assembly housing 13.

In some embodiments, the main housing 11 includes a third sub-accommodation cavity 1021, and the assembly housing 13 includes a fourth sub-accommodation cavity 1022. When the main housing 11 is connected to the assembly housing 13, the third sub-accommodation cavity 1021 and the fourth sub-accommodation cavity 1022 form the second accommodation cavity 102.

Referring to FIG. 4, the core assembly 1002 further includes a bone conduction driver 30 disposed within the second accommodation cavity 102. The bone conduction driver 30 is configured to produce a bone-conduction sound. In some embodiments, the first housing wall 1101 is in contact with the facial skin at the face region M. In turn, the bone conduction driver 30 is configured to push the physical load (e.g., the first housing wall 1101, user tissues, bones, etc.) to produce the bone-conduction sound.

In the embodiments provided in the present disclosure, it should be appreciated that the disclosed methods, as well as the apparatus, may be realized in other ways. For example, the implementations of the apparatus are merely schematic, e.g., the division of the modules or units is merely a logical functional division, and the actual implementation can be divided in another way, e.g., multiple units or components can be combined or can be integrated into another system, or some features can be ignored, or not implemented.

Units illustrated as separated components may or may not be physically separated, and components shown as units may or may not be physical units, i.e., they may be located in a single place or may be distributed over multiple network units. Some or all of these units may be selected to fulfill the purpose of the present embodiment of the scheme according to actual needs.

Also, the various functional units in the various embodiments of the present disclosure may be integrated in a single processing unit, or the individual units may be physically present individually, or two or more units may be integrated in a single unit. The above integrated units can be implemented either in the form of hardware or in the form of software functional units.

The above description is only exemplary embodiments of the present disclosure and does not, therefore, limit the scope of the present disclosure. Any structures or processes that are equivalent to those described in the present disclosure and drawings, or any applications directly or indirectly implemented in other related technical fields, are equally intended to be encompassed within the scope of protection of the present disclosure.

## Claims

1. An acoustic output device, comprising a housing and an air conduction driver, wherein:
the air conduction driver is disposed within the housing, the housing includes a first acoustic cavity and a second acoustic cavity, the first acoustic cavity and the second acoustic cavity are located on two sides of a diaphragm of the air conduction driver, respectively, the housing is provided with a sound outlet hole, a first pressure relief hole, and a second pressure relief hole, the sound outlet hole is in communication with the first acoustic cavity, and the first pressure relief hole and the second pressure relief hole are in fluid communication with the second acoustic cavity;
the housing defines a first direction, a second direction, and a third direction that are orthogonal to each other, the housing includes a first housing wall and a second housing wall arranged at intervals in the first direction, the housing further includes a third housing wall connecting the first housing wall and the second housing wall, the first pressure relief hole is disposed on the third housing wall, and the second pressure relief hole is disposed on the second housing wall; and
in a wearing state, the first housing wall faces toward a head of a user, the second housing wall is arranged at a side of the first housing wall opposite to the head of the user, and the third housing wall is located on a side of the housing opposite to a crown of the head of the user in the third direction.

2. The acoustic output device of claim 1, wherein an opening area of the second pressure relief hole is not less than 4 mm².

3. The acoustic output device of claim 1, wherein the housing further includes a fourth housing wall, the fourth housing wall is arranged at intervals from the third housing wall in the third direction and connects the first housing wall and the second housing wall, and in the wearing state, the fourth housing wall is located on a side of the housing facing toward the crown of the head of the user in the third direction; and
the second pressure relief hole is located closer to the fourth housing wall in the third direction than the third housing wall.

4. The acoustic output device of any one of claims 1 to 3, wherein the second pressure relief hole is arranged in an elongated shape, and a width of the second pressure relief hole is not greater than 1 mm.

5. The acoustic output device of any one of claims 1 to 3, further comprising a button mounted on the second housing wall, wherein the button and the second pressure relief hole are at least partially overlapped in the second direction.

6. The acoustic output device of claim 5, wherein in the wearing state, the second pressure relief hole is located closer to an ear of the user in the second direction than the button.

7. The acoustic output device of any one of claims 1 to 3, wherein the second housing wall is provided with a microphone hole; and
in the second direction, the microphone hole is located on a side of the second pressure relief hole away from the sound outlet hole, and the microphone hole and the second pressure relief hole are located close to opposite edges of the second housing wall, respectively.

8. The acoustic output device of any one of claims 1 to 3, further comprising a mesh,
wherein the mesh is connected to the housing and located at the second pressure relief hole.

9. The acoustic output device of claim 8, wherein the housing is further provided with an embedding groove located at an inner side of the second housing wall, the acoustic output device further comprises an inserting block, the inserting block is inserted into the embedding groove and fixed relative to the housing, and the mesh is disposed between the inserting block and the housing and covers the second pressure relief hole.

10. The acoustic output device of claim 9, wherein the inserting block is provided with a sound guide hole, and when the inserting block is inserted into the embedding groove, the sound guide hole and the second pressure relief hole are at least partially overlapped, and the inserting block forms an annular abutting region with an inner wall surface of the second housing wall around a periphery of the sound guide hole and the second pressure relief hole.

11. The acoustic output device of claim 9, wherein the housing is further provided with a support surface for supporting the inserting block in the second direction, the mesh includes a mesh body and an extension portion, the mesh body is disposed between the inserting block and an inner wall surface of the second housing wall, and the extension portion is bent and connected to the mesh body and is disposed between the inserting block and the support surface.

12. The acoustic output device of claim 11, wherein a first accommodation groove and a second accommodation groove are disposed on the inserting block, the mesh body is accommodated and fixed within the first accommodation groove, and the extension portion is accommodated and fixed within the second accommodation groove.

13. The acoustic output device of claim 9, wherein a first flange for supporting the air conduction driver is disposed on an inner wall surface of the second housing wall, the embedding groove forms a first notch on the first flange, and the inserting block is provided with a first filling portion for filling the first notch.

14. The acoustic output device of claim 13, wherein the housing further includes a cover body disposed on an end surface of the second housing wall, the end surface of the second housing wall is provided with a second flange for positioning the cover body, the embedding groove forms a second notch on the second flange, and the inserting block is provided with a second filling portion for filling the second notch.

15. The acoustic output device of claim 9, wherein the housing further includes a partition wall, and the partition wall is configured to separate an internal space of the housing into a first accommodation cavity and a second accommodation cavity arranged at intervals from each other, the first accommodation cavity and the second accommodation cavity are disposed in the second direction, the first accommodation cavity is located closer to an ear of the user than the second accommodation cavity is, the air conduction driver is accommodated within the first accommodation cavity, and the acoustic output device further comprises a bone conduction driver disposed within the second accommodation cavity.

16. The acoustic output device of claim 15, wherein the embedding groove forms a positioning recess on the partition wall, and the inserting block is inserted into the positioning recess.
